# EUROPEAN PATENT SPECIFICATION

(11) **EP 3 142 467 B1**
(45) Date of publication and mention of the grant of the patent: **12.05.2021**
(21) Application number: 16386016.6
(22) Date of filing: 08.09.2016
(51) Int. Cl.: H01J 37/32, H05H 1/24

(54) **LARGE AREA, UNIFORM, ATMOSPHERIC PRESSURE PLASMA PROCESSING DEVICE AND METHOD USING THE DEVICE**
GROSSFLÄCHIGE UNIFORME ATMOSPHÄRENDRUCK-PLASMAVERARBEITUNGSVORRICHTUNG UND VERFAHREN MIT DER VORRICHTUNG
DISPOSITIF DE TRAITEMENT PAR PLASMA À PRESSION ATMOSPHÉRIQUE UNIFORME A GRANDE SURFACE ET PROCÉDÉ UTILISANT LE DISPOSITIF

(30) Priority: 09.09.2015 GR 20150100397
(43) Date of publication of application: 15.03.2017
(73) Proprietor: NATIONAL CENTER FOR SCIENTIFIC RESEARCH "DEMOKRITOS", 15341 Agia Paraskevi Attikis (GR); Gogolides, Evangelos, 15341 Agia Paraskevi Attikis (GR)
(72) Inventor: Gogolides, Evangelos, 15341 Agia Paraskevi Attikis (GR); Zeniou, Angelos, 15341 Agia Paraskevi Attikis (GR); Dimitrakellis, Panagiotis, 15341 Agia Paraskevi Attikis (GR)

(56) References cited:
- DE-A1-102006 004 040
- JP-A- 2005 123 159
- JP-A- 2010 149 053
- JP-A- 2011 154 973
- US-A1- 2013 084 409

## Description

### Field of the Invention

The present invention relates to the field of plasma processing of materials in atmospheric conditions rather than vacuum, and in equipment used for performing such plasma processing. It also relates to plasma etching and controlled roughening of materials under atmospheric conditions.

### State of the art and background of the invention

Material processing with gas discharges, also known as plasmas, is an important field of manufacturing. Typically, plasmas under vacuum (i.e. low pressure) are used, although some cases of atmospheric pressure plasmas exist, such as the corona discharge *[*M. Ragoubi, B. George, S. Molina, D. Bienaimé, A. Merlin, J.-M. Hiver, A. Dahoun, Effect of corona discharge treatment on mechanical and thermal properties of composites based on miscanthus fibres and polylactic acid or polypropylene matrix, Composites: Part A, 2012, 43: 675-685*].* Today atmospheric pressure plasmas are growing as an interesting alternative to low pressure plasmas for several applications, due to the possibility to develop continuous processing without the costs of vacuum technologies. Several types of atmospheric discharges exist, such as corona, hollow cathode, and dielectric barrier discharges (DBD), the latter being a very interesting solution. DBDs have been widely used in industrial applications such as ozone generators, plasma display panels, excimer lamps, volatile organic compound destruction and surface modifications. DBDs are low temperature, non-equilibrium, transient gas discharges operating in a quasi-continuous discharge regime. They usually consist of two electrodes (at least one of them covered with a dielectric material) to which an AC high voltage is applied for frequencies generally varying in the range of 102 Hz to 102 kHz, although recently Radio Frequency (RF e.g. 13.56MHz) has been used. At low pressures DBDs operate in a Townsend breakdown regime generating a diffuse glow discharge. At atmospheric pressure, the realization of a diffuse discharge is more difficult and is restricted to limited conditions of geometry, electrical parameters and gas composition. Thus, often atmospheric DBDs operate usually in a streamer discharge in which several narrow discharge filaments are typically formed.

Material processing requires that plasma reactions are fast and uniform over large areas, so that large area processing and without filaments is possible in order to avoid material damage, especially when soft materials are used. Thus, there is a need to develop atmospheric plasma sources capable for uniform, large area, fast atmospheric plasma processing, with low power and low Helium gas consumption. Helium is the main carrier gas used due to its lower breakdown voltage in order to reduce the voltage required to start the discharge.

Several approaches have been proposed to allow a glow-type atmospheric discharge in volume (see the review paper by Klaus Dieter Weltmann, Eckhard Kindel, Thomas von Woedtke, Marcel Hähnel, Manfred Stieber, and Ronny Brandenburg, Atmospheric-pressure plasma sources: Prospective tools for plasma medicine, Pure Appl. Chem. 2010, Vol. 82, No. 6, pp. 1223-1237.)

Concerning DBD discharges, several configurations have been proposed for uniform, large area processing:
a) In several cases the sample is inserted between two parallel electrodes, typically on the grounded one, while power is applied on the top electrode on which a dielectric is attached, separated by a few millimeter gap from the sample. In such configuration it is difficult to control the He flow needed for the plasma breakdown. Lack of uniformity arises if the gas has to enter in a direction perpendicular to the air gap.
b) Therefore, a showerhead has often been used as described by Chia-Chiang Chang et al [Chia-Chiang Chang, Jin-Ching Wu, Chih-Wei Chen, Wen-Tung Hsu, US20090162263, (2009*)],* and by Chang Bo Jung et al. [Chang Bo Jung, Jong Han Jeong, Hyun Jo So, Dong Woo Yu, Steven Kim, US20020148816, (2002*)]* who treated printed circuit boards, as well as by Kwon et who treated polypropylene films [Kwon, O. J.; Tang, S.; Myung, S. W; Lu, N.; Choi, H. S., Surface characteristics of polypropylene film treated by an atmospheric pressure plasma. Surface and Coatings Technology 2005, 192 (1), 1-10*].*
c) Cylindrical - planar designs have also been proposed for large area processing, having also potential for roll to roll processing. In such designs a copper tube coil is surrounded by a dielectric cylinder and is powered, while a second, parallel, grounded planar electrode at a small distance hosts the sample, which may be moving. *[*Tatsuzo Tasinaki; US5391855, (1995*),* Cui, N. Y.; Brown, N. M. D., Modification of the surface properties of a polypropylene (PP) film using an air dielectric barrier discharge plasma. Applied Surface Science 2002, 189 (1-2), 31-38*.* Borcia, G.; Anderson, C. A.; Brown, N. M. D., Dielectric barrier discharge for surface treatment: Application to selected polymers in film and fiber form. Plasma Sources Science and Technology 2003, 12 (3), 335-344*,* Upadhyay, D. J.; Cui, N. Y., Meenan, B. J.; Brown, N. M. D., The effect of dielectric barrier discharge configuration on the surface modification of aromatic polymers. Journal of Physics D: Applied Physics 2005, 38 (6), 922-929*,* Cui, N. Y.; Upadhyay, D. J.; Anderson, C. A.; Brown, N. M. D., Study of the surface modification of a Nylon-6, 6film processed in an atmospheric pressure air dielectric barrier discharge. Surface and Coatings Technology 2005, 192 (1), 94-100*.*]
d) By far the most popular atmospheric plasma approach is the "curtain" configuration. In this approach the plasma is created as a perpendicular curtain between two horizontal electrode beams surrounded by a dielectric and separated by a few millimeter distance. Gas enters in between the beams while the sample is moving on a bottom grounded electrode. The plasma processing zone may be only the curtain, or the plasma may extend horizontally over the surface of the sample, if a small sample distance is chosen from the beams and the sample sits on a grounded electrode. [Hwang, Y. J.; McCord, M. G.; An, J. S.; Kang, B. C.; Park, S. W., Effects of helium atmospheric pressure plasma treatment on low-stress mechanical properties of polypropylene nonwoven fabrics. Text. Res. J. 2005, 75 (11), 771-778*,* Kim, M. C.; Klages, C. P., One-step process to deposit a soft super-hydrophobic film by filamentary dielectric barrier discharge-assisted CVD using HMCTSO as a precursor. Surface and Coatings Technology 2009, 204 (4), 428-432*.* Boscher, N. D.; Duday, D.; Verdier, S.; Choquet, P., Single-step process for the deposition of high water contact angle and high water sliding angle surfaces by atmospheric pressure dielectric barrier discharge. ACS Applied Materials and Interfaces 2013, 5 (3), 1053-1060*.* Avramidis, G.; Hauswald, E.; Lyapin, A.; Militz, H.; Viöl, W; Wolkenhauer, A., Plasma treatment of wood and wood-based materials to generate hydrophilic or hydrophobic surface characteristics. Wood Material Science and Engineering 2009, 4 (1-2), 52-60*. Dirk Vangeneugden, Roel Dams, Method for atmospheric plasma deposition of conjugated polymer coatings,* 2009, US 20090148615A1*. Dirk Vangeneugden, Erwin Van Hoof, Robby Rego, Method and device for atmospheric plasma treatment,* 2013, US20130084409A1*,* Kang, W S.; Hur, M.; Lee, J. O.; Song, Y. H., Controlling hydrophilicity of polymer film by altering gas flow rate in atmospheric-pressure homogeneous plasma. Applied Surface Science 2014, 295, 198-202*.*]
e) Another approach is to use a DBD as a surface discharge. Here the dielectric has on one side a metallic plane as an electrode, and on the other side a patterned grounded electrode. When applying voltage across the dielectric a surface discharge is generated and can be used for material processing. [K. Oehmigen, M. Hähnel, R. Brandenburg, C. Wilke, K.-D. Weltmann, T. von Woedtke. PlasmaProcess. Polym. 7, 250 (2010*).* U. Kogelschatz, B. Eliasson, W. Egli. J. Phys. IV 7, 47 (1997*), Shibata Tetsuji, Yamazaki Keiichi; Taguchi Noriyuki, Sawada Koji, Plasma Processing Apparatus, Method for Manufacturing Reaction vessel for Plasma Generation, and Plasma Processing Method,* JP2005123159 (A) (2005*).*]

A similar approach is to use an indirect plasma treatment, which usually incorporates two chambers one for the plasma creation and another for the sample treatment sometimes in vacuum, [*Oinuma Manabu, Inanaga Yasutaka, Tanimura Yasuhiro, Watanabe Kenshi, Hanada Masahito, Plasma treatment Device and Plasma Treatment Method,* JP5328685 (B2) (2011*)].*

Both methods are for remote plasma treatment and the sample is being treated only with the use of radicals and neutrals.
f) Several variations of the DBDs have also been used for particle matter (PM) removal in catalysts for the car industry. Some of these designs include planar wire or mesh electrodes separated by dielectric plates and have also a potential for uniform processing, although this was not proven, since they were not designed for this application. There are many patents for Diesel PM removal with plasma using either a DBD parallel electrodes or a stack of DBDs. The main role of the plasma reactor is the Oxidation of PM created by diesel engines and their removal. Several silent mode or DBDs devices that work in a glow discharge regime and not the filamentary regime have been patented: [*Nelson, D.E., Li, B.X., Lessor, D.L., Non-thermal plasma reactor substrate design-E-shape with low loss electrode pattern,* US6821493 (2004*)., Carlow, J.S., Ng, K. L., Shawcross, J.T., Reactor for plasma assisted treatment of gaseous,* US7163663 (2007*), Cotton, J.S., Combined EGR cooler and plasma reactor,* US7398643 (2008*), Birckigt, R., Hammer, T., Kishimoto, T., Method for reducing particle emissions containing carbon of diesel motors and corresponding system,* US6938409 (2005*),* Yamamoto S, Yao S, Kodama S, Mine C, Fujioka Y. Investigation of transition metal oxide catalysts for diesel PM removal under plasma discharge conditions. Open Catal. J2008; 1: 11-16*, Sato Shingo, Dielectric Structure, Discharge Device Using the Dielectric Structure, Fluid Modification Device, and Reaction System,* JP2010149053 (A), 2010*.*]

In addition to DBDs hollow cathode discharges have been also proposed for large area processing, however their inherent nature as hollow-cathode discharges places a limit on local uniformity. [H. Baránková, L. Bardos, Appl. Phys. Lett. 76 (2000) 285*. L* Bárdoš, H Baránková, Surface and Coatings Technology, 133-134, 2000, 522-527*].*

In all of the above approaches there is a difficulty to obtain uniform, large area, fast treatment of materials. Even if some designs and commercial equipment such as those incorporating plasma "curtains" allow uniform processing, this is limited to surface wetting modification and very thin film deposition. Practically no plasma etching reports exist with atmospheric plasma, and for those existing the reported etching rates are well below 10nm/min, while surface topography is inexistent. In addition, current designs consume significant amounts of power and Helium for their operation, or rely on the use of thick dielectrics (several millimeters thick), and large voltages for discharge breakdown. It seems that the typical approach of two electrode configuration device has several limitations, while the stability of a uniform glow versus spurious filamental discharges may be problematic. On the other hand, three electrode configurations using patterned or grid electrodes, such as those found on surface DBDs or DBD used for car catalysts, or hollow cathode discharges have problems of local uniformity, and often expose the metal surfaces to the plasma potentially contaminating the treated sample. Furthermore, in DE 10 2006 004040 A1 a dielectric barrier discharge device is disclosed that uses a patterned electrode to locally affect the electric field in order to introduce ripples on the substrate.

The present invention comes to fill in this gap by providing a uniform, large area, multi-electrode, multi-dielectric "perforated DBD sandwich antenna discharge" device capable to operate efficiently, thus utilizing lower voltages and powers. Reduction of voltages is possibly due to the use of thin (capable of being sub millimeter thick) electrodes and dielectrics if desired. The discharge can perform ultra-fast material (e.g. polymer) etching with etching rates exceeding 500nm/min at low powers. In addition, the discharge device can control the transition from uniform to filamental plasma discharge. Finally, the discharge device allows control of the surface topography by allowing rough surface creation and super-hydrophobic surface fabrication.

The present invention relates to the field of atmospheric plasma processing of materials and especially to a Large Area, Uniform, Atmospheric Pressure Plasma Processing device hereafter referred to as "perforated DBD sandwich antenna discharge". Thus, a new dielectric barrier gas discharge device here after referred to as "perforated DBD sandwich antenna discharge" is presented comprising a dielectric material with a metallic plate as an electrode on one side and a metallic antenna on the other side which is conformally coated with a second dielectric material. The whole structure in the form of "sandwich" is perforated with carefully designed holes arranged to allow gas injection. The metallic electrode is powered, the metallic antenna is connected to the metallic electrode or floating through a relay, while an air gap separates the source from a third grounded electrode optionally covered with a third dielectric, on which the sample sits. The new "perforated DBD sandwich antenna discharge" design allows fast, uniform, large area, etching and if desirable nanostructuring of materials, while it can also be used for uniform, large area deposition. According to another embodiment of the invention an alternative antenna configuration termed "double sandwich" antenna is also possible, where below the conformable dielectric, a second electrode or grid electrode is inserted and grounded for indirect treatment, whereby an optional fourth electrode may be used as a sample holder.

In addition, the invention relates to an etching or deposition process by using the inventive device as well as to a process of creating micro nano rough surfaces by using the inventive device.

### Brief description of the drawings

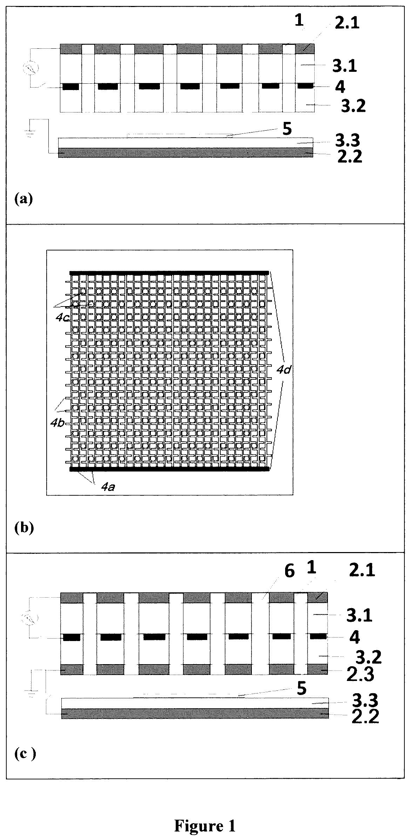

Figure 1. Schematics and variations of the proposed Large Area, Uniform, Atmospheric Pressure Plasma Processing device.
   (a) Cross section schematic of the proposed new source. 1=hole, 2.1, 2.2 are metal layers, 4 is a metallic antenna layer which builds an electrode powered or floating using a relay, 3.1, 3.2, 3.3 are dielectrics, 5 is a sample to be processed.
   (b) Top view of the proposed metallic antenna electrode, denoted as 4 in Fig. 1a. 4.d=metal line connecting the antenna loops, 4.a=metal loop connecting the metal pins, 4.b=metal pins, 4.c=holes for gas injection.
   (c) Alternative design of the proposed new source allowing sample to be out of the electrode region if desired. 1=hole, 6=optional dielectric tube inserted in the hole. 2.1 =powered metal layer, 4= metallic antenna layer powered or floating using a relay. 2.3=grounded metallic electrode. 3.1, 3.2=dielectrics, 5=samplebeing out of the electrode zone or sitting on optional: 3.3=dielectric, and 2.2=optional metal electrode, optionally grounded.

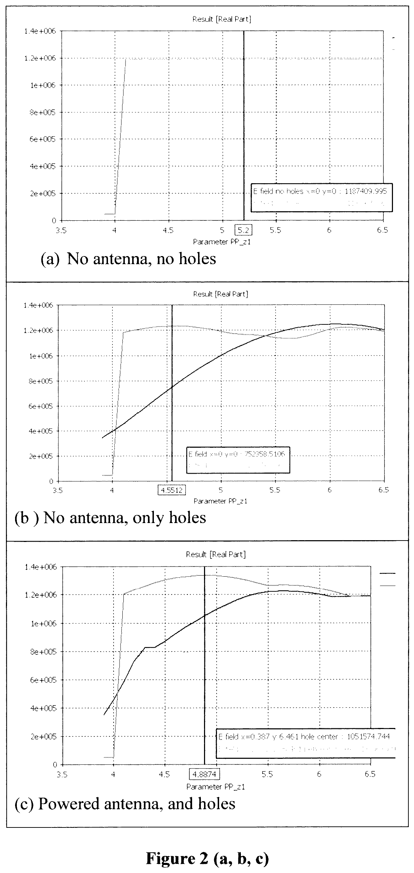

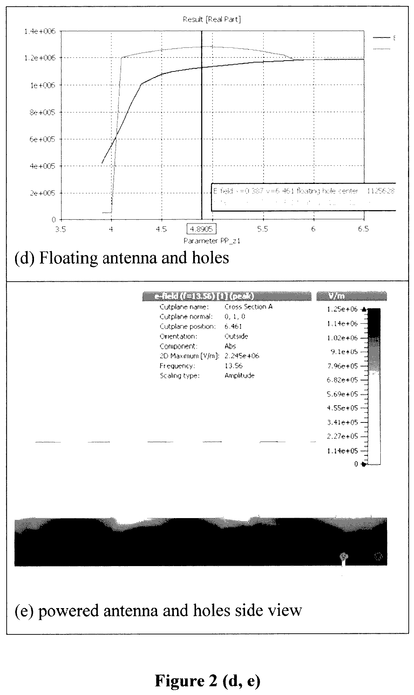

Figure 2. Comparison of Electric field distribution (from simulations) across the gap (from position 4mm to 6.5mm) of devices according to the invention:
   (a) Two electrode device, each electrode covered with a dielectric and separated with a gap, but without antenna, and without holes perforating the electrodes and dielectric. The electric fields are constant.
   (b) The same device as (a) but with holes perforating the electrodes and dielectric. Two curves are shown: One in the x, y position along the central axis extending out of the holes (lower fields), and a second in an x, y position in between to neighbouring holes. There are some changes in the fields, which are lower and not as uniform as in (a).
   (c) Electric field distribution for a proposed device, with a powered antenna. As can be deducted from (c) the electric fields are significantly higher compared to (a) in an x, y position in between to neighboring holes, whereby the electric fields in the axis of the holes after z position 5.4mm are higher compared to (a).
   (d) Electric field distribution for a proposed device, with a floating antenna. Compared to a device according to figure (a) the electric fields in an x, y position in between to neighboring holes and the electric fields in the axis of the holes are higher.
   (e) A cross section of the electric field distribution of case (c) above, for the powered antenna. Dark values signify very high electric fields. With the exception of the hole exit in the gap, the electric field distribution is very uniform, guaranteeing a uniform plasma, which breaks down at smaller voltages compared to case (a) due to the higher electric fields.
Figure 3. (a) Breakdown nominal RF power versus % O2 in the He/O₂ mixture, and (b) Voltage amplitude versus dissipated RF power in the discharge for the three different electrode configurations (no antenna grid, grid floating and grid powered).
Figure 4. Etching rate of a polymeric film (PMMA), (a) versus % O₂ and (b) versus nominal power for the three different electrode configurations (no antenna grid, grid floating and grid powered).
Figure 5. Digital camera images of the light emission from the plasma through a glass electrode at two powers (a) 80W, and (b) 120W. Notice the uniformity of the plasma emission, guaranteeing uniform processing. The holes are visible as non-uniformity simply because stray light through the holes is detected by the camera.

### Detailed description of the invention

Schematic views of the proposed Large Area, Uniform, Atmospheric Pressure Plasma Processing device "perforated DBD sandwich antenna discharge" are given in Fig. 1a, b, c. Fig. 1a shows a cross section of a first embodiment of the device, while Fig. 1b shows a top view of the metallic antenna electrode denoted as 4 in both figures 1a and 1b. The device comprises a first dielectric material (denoted as 3.1 in Fig. 1a) metalized on both sides (see the metal layer which builds a first metallic powered electrode 2.1 and the metallic antenna layer 4 which builds a second layer in Fig. 1a). Dielectric materials include those used for Printed Circuit Board (PCB) fabrication, or other polymeric or inorganic dielectrics having a thickness typically between tenth of a millimeter to a few millimeters, depending on the power to be applied. If large power densities are to be applied dielectric materials with low dielectric losses are preferred. The metallic powered electrode (see 2.1 in Fig. 1a) may be a metal plate or a metal layer deposited on the dielectric. On the other side of the dielectric 3.1 a patterned metallic layer exists in the form of an antenna (see Fig. 1b) and can be a thin perforated metallic plate or a printed antenna. The antenna 4 consists of loops of metal, which may be isolated or connected from the top or from the bottom or from both sides with a metal line with a relay Pins are protruding out of the metal loops of the antenna (denoted as 4.b in Fig. 1b). Typical dimensions of the loops are between a few millimeters up to a few 100s of millimeters in length and a few millimeters up to some 10s of millimeters wide, while the length of the pins are between 1 millimeter up to 10s of millimeters, and spacing between 6 millimeters down to 1 millimeter. In the embodiment shown in Fig. 1a the metallic antenna electrode denoted as 4 can be powered or floating by means of a relay.

A second conformable thin dielectric layer covers conformally the patterned metallic layer (see 3.2 in Fig. 1a). Typical thickness of this second dielectric is again in the range of tenth of a millimeter to a few millimeters. Typical materials include poly (dimethyl) siloxane polymer, or other polymeric material which can cover the few hundred-micron topography created between the antenna and the first dielectric removing any air gaps, or deposited or grown inorganic dielectric on top of the antenna. The electrode / dielectric sandwich construction is perforated with holes between 1-3mm in diameter (denoted as 1 in Fig. 1a, and as 3 in Fig. 1b) from which gases enter the device. The holes are spaced appropriately so that the electric fields generated interact. Thus, spacing values close to the diameter value are used. If the holes are far apart there is no interaction of the electric fields, while if they are very close together the total electric fields are reduced. Thus, preferably the hole diameter is on the order of 1-3mm, and more preferably 2mm, while the distance among the hole centers varies between 1.5 to 3 diameters, hence between 3 to 6mm.

The sandwich source is separated by a few mm gap (typically 1-10, with optimal distances in the range 2-5mm) from the sample (denoted as 5 in Fig. 1a), which is sitting on a grounded third electrode (denoted as 2.2 in Fig. 1a) facing the second conformable thin dielectric layer 3.2. An optional third dielectric (denoted as 3.3 in Fig. 1a) exists on this grounded electrode, and the sample sits on the dielectric in this case (see fig. 1a). The bottom dielectric / electrode 3.3 configuration may again be a one sided metalized PCB or a glass plate covered with conductive ITO (Indium Tin Oxide), or any low dielectric loss inorganic or organic dielectric metalized on one hand. The thickness of the dielectric varies again from sub millimeter to a few millimeters. If thick dielectric samples are to be treated, thin electrode dielectrics are chosen with low dielectric loss.

In the described design plasma processing takes place within the electrode configuration. However, out of the electrodes (remote like) plasma processing is possible in a "plasma-jet" type format.

In Fig. 1c an alternative embodiment is shown, a "double sandwich" antenna, where below the second conformable thin dielectric layer 3.2 shown in Fig. 1a, a second antenna building a fourth grid electrode is inserted (denoted as 2.3) and grounded. To avoid sparking in the holes when operating at large powers, thin-walled dielectric tubes are inserted inside the holes 1 (denoted as 6 in Fig. 1c). The tubes 6 may be from any low loss dielectric material, such as alumina, quartz or other. In this design the sample (denoted as 5 in Fig. 1c) may be "free-standing", or sitting on a third electrode (denoted as 2.3 in Fig. 1c) optionally grounded and optionally covered with an optional third dielectric (denoted as 3.3 in Fig. 1c). In the embodiment shown in Fig. 1c the third electrode 2.3 can be grounded or floating by means of a relay.

This alternative compact design creates multi-jets of plasma using a flat design, which can be materialized even on a PCB.

Unique advantages of the "perforated DBD sandwich antenna discharge" according to the invention are the following:
(a) It is scalable for any small or large size. Therefore, it can be used for large area treatment, or even miniaturized to be used for chip, biochip, microfluidic, microarray or other small surface treatment. When used for large area treatment the antenna loops may be enlarged up to a dimension of a few hundreds of centimeters or use the smaller with a few 100s of millimeters design that will include multiple copies of the antenna design connected together and powered with parallel connection.
(b) It allows uniform plasma treatment.
(c) The perforated design allows uniform helium injection, and creates local enhancement of the electric fields in the area surrounding the hole compared to those existing between the equivalent two electrode configuration (i.e. similar design without the antenna and without the holes). This enhancement allows plasma breakdown at lower voltages.
(d) More specifically, the existence of the antenna in floating or powered configuration significantly enhances the electric fields in the whole gap area. First, electric fields are significantly enhanced compared to the two electrode configuration in the area surrounding the holes. Second, the electric field is also enhanced in the hole at a specific distance between the gaps. The position of enhancement is controlled by powering or floating the antenna, and the antenna design. Therefore, this design allows lower power to be applied in order to start the discharge, and more uniform and stable operation.

In addition to the above, the proposed "perforated DBD sandwich antenna discharge" has several processing advantages as well. It can accommodate any size of samples, it can be used for uniform processing, needs lower power to start the plasma and lower power in operation, as well as less Helium flow. Several materials can be processed in the discharge including organic polymers (such as Poly(methyl) methacrylate (PMMA), Cyclo Olefin polymer (COP), Poly(styrene) (PS), Poly(ether) etherketone (PEEK), Teflon-like polymers, poly(imide) (PI), photoresists and others) or organic-inorganic polymers (such as poly(dimethyl) siloxane (PDMS), or polymers with fillers, such as those used for printed circuit boards or others). These materials can be etched with very small quantities of oxygen flow at extremely high etching rates reaching several microns per minute, which is not possible today with other atmospheric plasma sources. Etching can take place using as carrier gas Helium or other noble gas such as Argon, and a few percent Oxygen or Fluorine containing gases. Using fluorine containing gases Si etching and inorganic polymer etching can be performed.

The source can also be used for fast and uniform deposition if a precursor or depositing gas is introduced together with the carrier gas. Fluorocarbon gases (such as CHF3, or CF4, or C4F8, or in CxHyFz in general gases), or fluorinated siloxane precursors (such as fluorinated ethoxysilanes, or fluorinated chlorosilanes), can be used for hydrophobic coating deposition. Oxygen containing molecules, such as alcohols, or ketones, or acids, can be used for hydrophilic polymer deposition. According, to the invention an etching or deposition process by means of the inventive device can be performed, whereby mixtures of etching gases or depositing gases and noble gases or Nitrogen are used and wherein etching or deposition rates in excess of 100 nm/min are achieved.

The source is also used for controlled micro and/or nano roughening of a surface either via etching or deposition of materials. The roughness should preferably comprise dual or multi roughness scales including micro and nano features. Surfaces include surfaces of polymers (such as those described above), or coated glasses or metals the coating being a film of the above polymers. Surfaces may also include surfaces of Silicon or semiconductors or metals. Roughening may be accomplished by using any of the following methods or their combination with the inventive device. In these methods, etching is effected in oxygen, or fluorine, or chlorine containing plasmas.
A) One method of roughening entails the creation of an initial topography on the surface, either by creating an ordered relief structure or pattern such as a lithographic pattern, or by randomly depositing a layer of micro or nano particles. During the step of plasma treatment this initial topography is transferred to the material being etched.
B) A second method relies on incorporating on the surface or the bulk of the material to be etched, unetchable material (often termed etch inhibitors). These inhibitors retard the etching locally and lead to surface roughness. Metallic or inorganic oxide nanoparticles could also be used to this extent.
C) A third method is based on co-deposition on the etched surface of etch inhibitors. This could be accomplished by inducing sputtering of: C1) the thin-walled dielectric tubes inserted inside the holes (denoted as 6 in Fig. 1c), or C2) the electrode dielectric material. In both cases sputtering can be induced by either high voltage operation or controlled micro streamer (micro filament) generation.
D) A fourth method is based on alternating the operation of the plasma between normal glow and controlled micro streamers (micro filaments), which lead to locally inhomogeneous etching rate and roughness. Such transitions between normal glow to micro streamers and again back to normal glow discharge can be accomplished by varying the operating parameters of the discharge: D1) One operating parameter to vary is the Helium (or other noble gas or Nitrogen) flow rate or the Helium (or other noble gas or Nitrogen) / Oxygen (or other reactive gas) flow ratio in the gas mixture, for example by pulsing the flow controllers. D2) A second operating parameter to vary is the power magnitude and / or frequency, e.g. performing decrease and increase of the frequency and / or the power applied in a cyclic way. D3) Yet another operating parameter to vary is the gap (spacing) between the ground and the powered plates, e.g. by increasing and decreasing the gap.
   These rough surfaces are hydrophilic and resist hydrophobic recovery for a period of months. In addition, such controlled roughening, followed by in situ or ex situ deposition of a thin (below 30nm) layer of low surface energy material, such as a fluorinated carbon polymer or monolayer, leads to the creation of extremely anti-wetting surfaces which repel water, oils and solvents, and are termed super hydrophobic or super oleophobic surfaces. In addition, such rough surfaces may be antireflective if the roughness elements are comparable to the wavelength of visible light.
E) Yet a fifth method to create superhydrophobic surfaces using the device is based on the deposition of a rough hydrophobic coating preferably with multi-scale roughness. Indeed, varying the operating parameters and the precursor gas composition nanoparticulates can be created inside the hydrophobic coating. Alternatively, one can follow a 2-step plasma deposition first of micro / nano particles (using a solution of particles and a carrier gas) and second of a hydrophobic coating using appropriate gases as described above.

Specific examples to be shown below demonstrating several of the advantages and applications of the present invention.

### Examples

### Example 1: Comparison of the electric fields generated by the "perforated DBD sandwich antenna discharge" and the simple non-perforated two electrode discharge

Using appropriate software, Maxwell equations have been solved to find the distribution of the electric fields in the area across the gap where the sample is situated. Simulations were conducted assuming a 13.56MHz excitation and a current of 10A, with a discharge area of approximately 100cm². The electric fields across the gap are compared for the two electrode configuration discharge (without antenna, without holes Fig. 2a), with the configurations of holes and no antenna (Fig. 2b), holes and powered antenna (Fig. 2c), and holes and floating antenna (Fig. 2c). The surface of the top dielectric is at position Z=4mm, and the gap extends between 4 and 6.5mm. As one can observe the electric field is uniform and constant across the gap for configuration 2a (no antenna, no holes). For the particular simulation the value of 1.2E6 V/m has been calculated. Fig. 2b shows the electric fields when the two electrode configuration is perforated with holes. Two lines are plotted: One line is for an X, Y position which does not correspond to the exit of a hole, the second at a position which corresponds to an extension of the central axis of a hole in the gap. As one can see the perforation slightly increases the electric fields in some areas, while it decreases in others, while the electric fields at the X, Y position of the holes across the gap are generally reduced significantly. Fig. 2c shows the result when the antenna is added as an electrode in the perforated design, the antenna being powered. One can notice the large increase of the electric field in the area around the X, Y position of the holes, as well as the significant increase of the fields at the position of the hole axis at several positions across the gap. Fig. 2d shows the electric fields when the antenna electrode is floating. One can see the electric fields are increased relatively to the case of no antenna, but are lower compared to the powered antenna. Finally, Fig. 2e shows a cross section of the sandwich showing the electric field distribution across the gap for all X, Y positions for the configuration of powered antenna with holes. Notice that if one excludes the hole outlet, fields are extremely uniform in the gap, and are generally at least 10% higher compared to the fields without holes and without the antenna. Given that Helium is usually ejected from the holes, the high values of electric field of the proposed device, allow easy local breakdown of the gas, and thus necessitate lower power to start the discharge. In addition, the powered grid configuration shows higher and uniform fields.

### Example 2: Lower breakdown power and higher voltage values with the "perforated DBD sandwich antenna discharge"

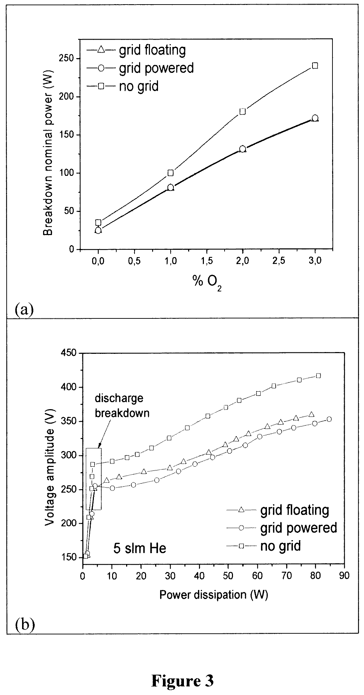

With the aid of Voltage-Current (V-I) probes and appropriate experimental set-up for electrical measurements, the atmospheric pressure dielectric barrier discharge was characterized concerning the electrical properties and a comparison was also made between four different configurations. More specifically, the comparison was focused on the following 4 configurations: (A) no holes, no grid simply a parallel plate discharge. This discharge has shown problems of repeatability and uniformity and is not discussed further, (B) with holes but with no antenna grid, (C) with holes and with the powered grid, and (D) with holes and with the floating antenna grid. In this example we experimentally verify the theoretical predictions of example 1. In fig. 3a we compare the robust, uniform and repeatable discharge configurations (B), (C), (D) and we prove that the nominal RF power needed to excite the He plasma is very low and also plasmas with Oxygen content as high as 3% are possible to excite, which is much difficult to achieve with the conventional DBD configuration (A). In Fig 3a the power needed to excite the plasma is higher for the no grid configuration (B). On the other hand, the addition of the antenna grid, either floating or powered (configuration (D), (C)) resulted in much lower values of plasma breakdown power for the same gas mixture. This is also confirmed by the graph of electrode voltage variation as a function of the power dissipated in it (fig 3b). It is obvious that the voltage value required for plasma excitation is much lower in the case of antenna grid addition.

Moreover, for constant power dissipation, the electrode voltage is lower for the source configurations with the grid and especially for the powered grid electrode in all range of powers examined in this text. This confirms that the simulation results shown in example 1 that the discharge can start more easily (e.g. at lower voltage) when a grid is present.

### Example 3: Very high etching rate of Poly(methyl) methacrylate polymer (PMMA) in "perforated DBD sandwich antenna discharge"

The device was used to etch PMMA films coated on Silicon wafers and placed on the bottom dielectric plate. Oxygen gas was introduced into helium at percentages ranging from 0-3%. Etching (i.e. polymer removal) experiments were conducted with a 13.56MHz excitation and powers from 100-250W, with a discharge area of approximately 25cm². Without oxygen in the mixture etching rates as high as 200nm/min were obtained, but are increased significantly when O₂ content increases.

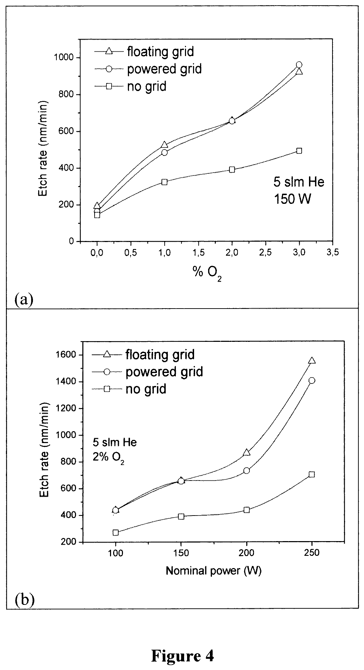

With the addition of 3% Oxygen at constant power etching rates as high as 1000nm/min were achieved (see Fig. 4a). Etching rates are further increased with the power and they reach values nearly 1.5µm/min at 250W nominal power (Fig 4b) From the figure it is obvious that it is possible to achieve very high etching rates with low input power in this device and relatively low % O₂ in the gas feed. Etching was observed to be uniform for the whole area used for this experiment.

### Example 4: Uniformity of the "perforated DBD sandwich antenna discharge"

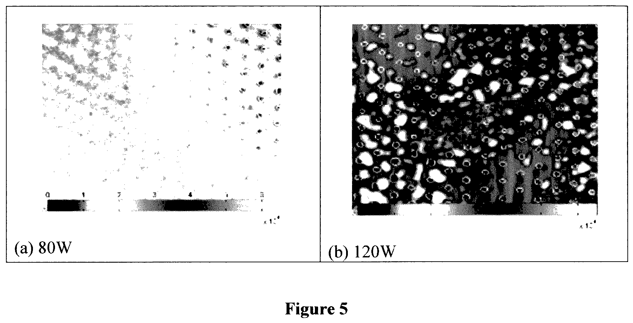

Experiments were conducted as described in example 3, without a PMMA sample. A CCD camera was used to monitor the intensity of the plasma through a bottom transparent glass dielectric coated with a conductive grounded ITO (Indium Tin Oxide) electrode. Fig. 5 shows the CCD images revealing very uniform processing over the whole discharge area. The particular images were taken for a He flow rate of 7slm, with similar results for other flows. Notice the uniform glow over an area of 10x10cm², and the increasing intensity as power is increased. Fig. 5a shows the image at a power of 80W, and Fig. 5b shows the image at a power of 120W which is of course much brighter (darker in the gray scale). It has to be noted that the holes are visible in these images, as light can come from the top through the holes. Thus, holes appear brighter (darker in the gray scale). This is not therefore a lack of local uniformity, but is due to the nature of the holes, allowing light to go through in addition to the light emitted by the plasma.

### Example 5: Wetting control of polymeric surfaces from hydrophilic to very hydrophobic surfaces using the "perforated DBD sandwich antenna discharge"

The device was also tested for wetting control of polymers and the results allow obtaining both hydrophilic and very hydrophobic surfaces (Table 1). Water contact angles (WCA) of the etched PMMA were measured just after plasma etching process and found to be less than 15°. Therefore, the device may be used for polymer hydrophilization. There is also proof of the long lasting PMMA hydrophilization (retarded hydrophobic recovery) as the water contact angle for the samples measured 30 days after plasma treatment was below 30°, around 35° lower than the untreated samples (-65°). On the other hand, the device can also be used for hydrophobization of polymers and other materials, if the atmospheric plasma etching is followed by fluorocarbon film deposition (i.e. low surface energy material deposition) using a C4F8 gas mixture with Helium. Such a deposited film is hydrophobic and shows a WCA ~110°. In addition, in this example we discuss the possibility to create very hydrophobic (superhydrophobic films) using the device. In one case we created an initial topography on the surface of PMMA films by spin-coating a solution of colloidal microparticles (1 µm diameter), which formed a layer of protruding spheres on the film. After etching for 10s only in a mixture of He and Oxygen at a power of 150W at 13.56MHz, a deposition of a fluorocarbon ultra-thin film followed using a fluorocarbon gas in the mixture. The combination of topography, which was transferred to the film during etching, and the low surface energy coating resulted in further increase of WCA in values higher than 140°. Finally, a PMMA film was etched initially in a glow discharge mode, alternating with a micro streamer mode discharge by using at 100kHz frequency and modulating the oxygen or He flowrate between a minimum and maximum value. The micro streamers resulted in roughness formation during etching. Following a deposition of a thin fluorocarbon coating, a WCA of 145° was reached, i.e. superhydrophobicity was produced. Those results prove the device potential for controlled surface roughening and fabrication of superhydrophobic polymeric surfaces.

**Table 1: Contact angles of plasma treated PMMA films. Hydrophilic and hydrophobic results are obtained.**

| PMMA film | Untreated sample | He plasma (fresh) | He plasma (30 days ageing) | He/O2 plasma + FC coating (no or very small topography) | He/O2 plasma + FC coating (colloidal microparticles-large topography) | He/O2 plasma + FC coating (alternating glow discharge and micro streamers, large topography) |
|---|---|---|---|---|---|---|
| WCA (deg) | 65 | < 15 | 29 | 110 | 140 | 145 |

## Claims

1. A Large Area, Uniform, Atmospheric Pressure Plasma Processing device comprising a first dielectric material (3.1) metalized on one side by a first powered metal (2.1), having on the other side a second patterned metallic layer (4) in the form of an antenna, the antenna being powered or floating and being covered conformally by a second dielectric (3.2), the whole electrode / dielectric construction being perforated with holes and separated by an air gap from a third grounded metal (2.2) electrode of the device facing the second dielectric optionally covered with a third dielectric (3.3), whereby a sample to be processed by the device is sitting on the third grounded metal (2.2) electrode.

2. A device according to claim 1, comprising an additional grounded metal grid or antenna (2.3) attached on the second dielectric (3.2) from the side facing the sample, the additional grounded metal grid or antenna being optionally covered conformally with a third dielectric.

3. A process of creating micro and/or nano rough polymeric or polymer-coated surfaces or bulks, or metallic or semiconductor surfaces or bulks using any of the devices described in claims 1 or 2, by applying any of the following steps or their combinations:
A) Creating an initial topography on the surface and applying plasma processing in the device in oxygen or fluorine or chlorine containing plasmas to transfer this initial topography on the surface being etched;
B) Incorporating on the surface or the bulk of the material to be etched, unetchable material or metallic or inorganic oxide nanoparticles and applying plasma processing in the device in oxygen or fluorine or chlorine containing plasmas;
C) Inserting thin-walled dielectric tubes inside the holes to avoid sparking in the holes when operating at large powers, and inducing sputtering of the thin-walled dielectric tubes or the electrode dielectric material, either by high voltage operation or by controlled micro streamer generation, where sputtering is induced simultaneously to etching of the surface in oxygen or fluorine or chlorine containing plasmas;
D) Alternating the operation of the plasma between normal glow and controlled micro streamers to effect locally inhomogeneous etching of the surface, in oxygen or fluorine or chlorine containing plasmas, whereby the alternating operation can be accomplished by alternating gas flowrate or power or frequency or electrode spacing;
E) Depositing micro-nano particles on the surface using the device and a gas carrier containing a solution of the particles.

4. A hydrophilic surface created by the process described in claim 3, wherein oxygen is used in the gas mixture, and hydrophilicity is retained for a period of months.

5. A superhydrophobic and antireflective surface created by the process described in claim 3, where in addition a fluorocarbon coating deposition takes place on top of the surface.

## Patentansprüche

1. Eine großflächige, gleichmäßige Atmosphärendruck-Plasmabearbeitungsvorrichtung, die ein erstes dielektrisches Material (3.1) umfasst, das auf einer Seite durch ein erstes bestromtes Metall (2.1) metallisiert ist und auf der anderen Seite eine zweite strukturierte Metallschicht (4) in Form einer Antenne aufweist, wobei die Antenne bestromt oder schwebend ist und gleichmäßig von einem zweiten Dielektrikum (3. 2) bedeckt ist, wobei die gesamte Elektroden-/Dielektrikumskonstruktion mit Löchern perforiert und durch einen Luftspalt von einer dritten geerdeten Metallelektrode (2.2) der Vorrichtung getrennt ist, die dem zweiten Dielektrikum zugewandt und gegebenenfalls mit einem dritten Dielektrikum (3.3) bedeckt ist, wobei eine von der Vorrichtung zu bearbeitende Probe auf der dritten geerdeten Metallelektrode (2.2) sitzt.

2. Eine Vorrichtung nach Anspruch 1, die ein zusätzliches geerdetes Metallgitter oder eine Antenne (2.3) umfasst, das/die auf dem zweiten Dielektrikum (3.2) von der der Probe zugewandten Seite angebracht ist, wobei das zusätzliche geerdete Metallgitter oder die Antenne optional gleichmäßig mit einem dritten Dielektrikum bedeckt ist.

3. Ein Verfahren zur Erzeugung von mikro- und/oder nanorauen polymeren oder polymerbeschichteten Oberflächen oder Körpern oder metallischen oder halbleitenden Oberflächen oder Körpern unter Verwendung einer der in den Ansprüchen 1 oder 2 beschriebenen Vorrichtungen, indem einer der folgenden Schritte oder deren Kombinationen angewendet wird:
A) Erzeugen einer Ausgangstopographie auf der Oberfläche und Anwenden einer Plasmabearbeitung in der Vorrichtung in sauerstoff- oder fluor- oder chlorhaltigen Plasmen, um diese Ausgangstopographie auf die zu ätzende Oberfläche zu übertragen;
B) Einarbeiten von nicht ätzbarem Material oder metallischen oder anorganischen Oxid-Nanopartikeln auf der Oberfläche oder der Masse des zu ätzenden Materials und Anwenden einer Plasmabehandlung in der Vorrichtung in sauerstoff- oder fluor- oder chlorhaltigen Plasmen;
C) Einsetzen von dünnwändigen dielektrischen Röhren in die Löcher, um Funkenbildung in den Löchern zu vermeiden, wenn mit großen Leistungen gearbeitet wird, und Induzieren des Sputterns der dünnwändigen dielektrischen Röhren oder des dielektrischen Elektrodenmaterials, entweder durch Hochspannungsbetrieb oder durch kontrollierte Erzeugung von Mikroströmungen, wobei das Sputtern gleichzeitig zum Ätzen der Oberfläche in sauerstoff- oder fluor- oder chlorhaltigen Plasmen induziert wird;
D) Abwechselndes Betreiben des Plasmas zwischen normalem Glühen und kontrollierten Mikroströmungen, um ein lokal inhomogenes Ätzen der Oberfläche in sauerstoff- oder fluor- oder chlorhaltigen Plasmen zu bewirken, wobei das abwechselnde Betreiben durch Abwechseln des Durchflusses des Gases oder der Leistung oder der Frequenz oder des Elektrodenabstandes erreicht werden kann;
E) Aufbringen von Mikro-Nanopartikeln auf die Oberfläche unter Verwendung der Vorrichtung und eines Gasträgers, der eine Lösung der Partikel enthält.

4. Eine hydrophile Oberfläche, die durch das in Anspruch 3 beschriebene Verfahren erzeugt wird, wobei Sauerstoff in der Gasmischung verwendet wird und die Hydrophilie für einen Zeitraum von Monaten beibehalten wird.

5. Eine superhydrophobe und antireflektierende Oberfläche, die durch das in Anspruch 3 beschriebene Verfahren erzeugt wird, wobei zusätzlich eine Fluorkohlenstoff-Beschichtung auf der Oberfläche aufgebracht wird.

## Revendications

1. Un dispositif de traitement uniforme de grandes surfaces par plasma à pression atmosphérique comprenant un premier matériau diélectrique (3.1), métallisé d'un côté par un premier métal sous tension (2.1), ayant de l'autre côté une deuxième couche métallique (4) façonnée sous la forme d'une antenne, l'antenne étant sous tension ou à potentiel flottant et étant recouverte uniformément par un deuxième diélectrique (3.2), l'ensemble électrode / assemblage diélectrique étant perforé de trous et séparé par un entrefer d'une troisième électrode métallique (2.2) du dispositif, connectée à la terre et placée face au deuxième diélectrique éventuellement recouvert d'un troisième diélectrique (3.3), moyennant quoi un échantillon à traiter par le dispositif repose sur la troisième électrode métallique connectée à la terre (2.2).

2. Un dispositif selon la revendication 1, comprenant une grille métallique, ou antenne, supplémentaire connectée à la terre (2.3) et fixée sur le deuxième diélectrique (3.2) du côté faisant face à l'échantillon, la grille métallique ou antenne supplémentaire connectée à la terre étant éventuellement recouverte uniformément d'un troisième diélectrique.

3. Un processus de création de surfaces ou de substrats, ou de surfaces ou substrats métalliques ou semiconducteurs, à micro et / ou nano-rugosités polymériques ou revêtus de polymère en utilisant l'un des dispositifs décrits dans les revendications 1 ou 2, en appliquant l'une des étapes suivantes ou leurs combinaisons:
A) Créer une topographie initiale sur la surface et appliquer un traitement au plasma dans le dispositif en utilisant des plasmas contenant de l'oxygène ou du fluor ou du chlore pour transférer ladite topographie initiale sur la surface à graver;
B) Incorporer sur la surface ou le substrat du matériau à graver, un matériau non-gravable ou des nanoparticules métalliques ou d'oxyde inorganique et appliquer un traitement au plasma dans le dispositif en utilisant des plasmas contenant de l'oxygène ou du fluor ou du chlore;
C) Insérer des tubes diélectriques à paroi mince à l'intérieur des trous pour éviter des étincelles dans les trous lors d'un fonctionnement à de fortes puissances, et induire une pulvérisation des tubes diélectriques à paroi mince ou du matériau diélectrique de l'électrode, soit par un fonctionnement à haute tension, soit par une génération contrôlée de microfilaments, où la pulvérisation se produit simultanément à la gravure de la surface dans des plasmas contenant de l'oxygène ou du fluor ou du chlore;
D) Alterner le fonctionnement du plasma entre régime à luminescence normale et à microfilaments contrôlés pour effectuer une gravure localement non homogène de la surface dans des plasmas contenant de l'oxygène ou du fluor ou du chlore, lequel fonctionnement alterné pouvant être accompli en alternant le débit de gaz ou la puissance ou la fréquence ou l'espacement des électrodes;
E) Déposer des micro-nano particules sur la surface à l'aide du dispositif et d'un gaz porteur contenant une solution de particules.

4. Une surface hydrophile créée par le processus décrit dans la revendication 3, de l'oxygène étant utilisé dans le mélange gazeux, et l'hydrophilie étant conservée pendant une période de plusieurs mois.

5. Une surface super-hydrophobe et antireflet créée par le processus décrit dans la revendication 3, où en plus un dépôt de revêtement de fluorocarbone se forme au-dessus de la surface.
